Europäisches Patentamt

**European Patent Office**

**Office européen des brevets**

(11) Numéro de publication: **0 138 727**

**B1**

(12) # FASCICULE DE BREVET EUROPÉEN

(45) Date de publication du fascicule du brevet: 13.01.88

(51) Int. Cl.⁴: **H 04 L 27/22,** H 03 D 3/16

(21) Numéro de dépôt: 84460006.0

(22) Date de dépôt: 09.10.84

(54) **Circuit de réception d'onde modulée tantôt en fréquence par signal analogique, tantôt en phase par signal numérique.**

(30) Priorité: 12.10.83 FR 8316325

(43) Date de publication de la demande: 24.04.85 Bulletin 85/17

(45) Mention de la délivrance du brevet: 13.01.88 Bulletin 88/2

(84) Etats contractants désignés: BE CH DE GB IT LI NL SE

(56) Documents cité:
FR-A-2 312 881
US-A-3 835 422
US-A-3 936 751
US-A-3 960 962
US-A-3 987 367
US-A-4 169 286

I.E.E. PROCEEDINGS SECTION AAI, vol. 129, no. 7, partie A, septembre 1982, pages 528-531, Old Woking, Surrey, GB; M.D. WINDRAM: "Multiple sound channels in satellite broadcasting"

(73) Titulaire: **Etablissement Public de Diffusion dit "Télédiffusion de France", 21- 27 rue Barbès, F-92120 Montrouge (FR)**
Titulaire: **Le Goff, Jeannine, épouse Henaff, 3ter, Place Marquis, F-92140 Clamart (FR)**
Titulaire: **Veillard, Jacques, La Viseule Montgermont, F-35760 Saint Gregoire (FR)**

(72) Inventeur: **Le Goff- Henaff, Jeannine, 3 ter Place Marquis, F-92140 Clamart (FR)**
Inventeur: **Veillard, Jacques, La Viseule, Montgermont, F-35760 Saint- Gregoire (FR)**
Inventeur: **Pommier, Daniel, Champ d'Alouette Bréal, F-35310 Mordelles (FR)**

(74) Mandataire: **Le Guen, Louis François, Cabinet Louis Le Guen 1, avenue Edouard VII B.P. 91, F-35802 Dinard Cédex (FR)**

## Description

La présente invention concerne un circuit de réception d'ondes électriques modulées alternativement, soit en fréquence par un signal analogique, soit en phase par un signal numérique, comportant un dispositif à ondes acoustiques de surface.

Un tel modulateur est prévu pour être utilisé notamment dans des systèmes de radiodiffusion par satellite dans lesquels le signal diffusé consiste en un multiplexage temporel entre une porteuse modulée en fréquence par le signal d'image pendant la durée active d'une ligne de télévision et une porteuse modulée en phase par un signal numérique pendant l'intervalle de suppression. Ce système de radiodiffusion par satellite est connu dans l'Unité Européenne de Radiodiffusion (UER) sous l'appellation "système C". Plus particulièrement, dans ce système, la modulation numérique utilisée est la modulation MDP2-4 qui consiste en une modulation binaire à déplacement de phase qui présente quatre états qui diffèrent de 90°, dans laquelle le symbole binaire 1 est transmis par un saut de phase de + 90° et le symbole 0 est transmis par un saut de phase de - 90°. La modulation MDP2-4 est complètement décrite dans le brevet EP-A-0 032 325. Elle présente l'intérêt d'avoir une enveloppe presque constante après filtrage. Dans le système C, le débit instantané du signal numérique est de 20,25 Mbit/s et la durée d'une salve est de 10 microsecondes.

Bien entendu, dans un équipement de réception du système C, il faut prévoir un étage d'amplification de la porteuse modulée, puis une division en deux voies dont l'une comporte un démodulateur analogique de fréquence qui délivre le signal d'image et l'autre un démodulateur différentiel numérique qui fournit le signal de données à 20,25 Mbit/s.

Un objet de l'invention consiste à prévoir un circuit à état solide dont le substrat supporte le démodulateur de fréquence et le démodulateur différentiel numérique.

Suivant une caractéristique de l'invention, il est prévu un circuit de réception, comprenant un dispositif à ondes acoustiques de surface, sur le substrat duquel sont prévus deux paires de transducteurs d'entrée reliées, en parallèle, à l'entrée du circuit de réception, les transducteurs d'entrée lançant des ondes acoustiques correspondant aux signaux appliqués à ladite entrée sur deux paires de pistes aboutissant à deux paires de transducteurs de réception, les longueurs des pistes de chaque paire de pistes étant différentes, les sorties des transducteurs de sortie de la première paire étant respectivement reliées aux deux entrées d'un premier mélangeur dont la sortie délivre le signal numérique reçu et les sorties des transducteurs de la seconde paire étant respectivement reliées aux entrées de deux limiteurs dont les sorties sont respectivement reliées aux deux entrées d'un second mélangeur dont la sortie délivre le signal analogique, la différence de longueur des pistes de la première paire apportant un retard de l'ordre de la durée d'un bit et la différence de longueur des pistes de la seconde paire apportant un retard égal à l'inverse du double de la largeur de bande entre les sommets du discriminateur ainsi constitué.

Suivant une autre caractéristique, chaque paire d'ensembles comprenant chacun une paire de transducteurs d'entrée et la paire de transducteurs de sortie associés comporte des peignes modulés lui donnant des réponses impulsionnelle et fréquentielle déterminées.

Suivant une autre caractéristique, chaque dite paire de transducteurs est remplacée par un seul transducteur de largeur double.

Suivant une autre caractéristique, lesdites paires de pistes sont parallèles, mais de sens de propagation inversés.

Suivant une autre caractéristique, lesdites paires de transducteurs d'entrée sont remplacées par un transducteur d'entrée unique bidirectionnel avec, d'un côté, une paire de pistes vers la première paire de transducteurs de sortie et, de l'autre côté, une autre paire de pistes conduisant à l'autre paire de transducteurs de sortie.

Les caractéristiques de l'invention mentionnées ci-dessus, ainsi que d'autres, apparaîtront plus clairement à la lecture de la description suivante d'exemples de réalisation, ladite description étant faite en relation avec les dessins joints, parmi lesquels:

la Fig. 1 est un diagramme illustrant le multiplexage des signaux transmis dans le système C,

la Fig. 2 montre un circuit de démodulateur de fréquence analogique connu,

la Fig. 3 est un schéma de démodulateur équivalent de celui de la Fig. 2,

la Fig. 4 est un bloc-diagramme d'un démodulateur suivant l'invention,

la Fig. 5 est une vue schématique d'un dispositif à ondes élastiques de surface suivant l'invention,

la Fig. 6 est une vue schématique d'une première variante du dispositif de la Fig. 5,

la Fig. 7 est une seconde variante du dispositif de la Fig. 5, et

la Fig. 8 est une troisième variante du dispositif de la Fig. 5.

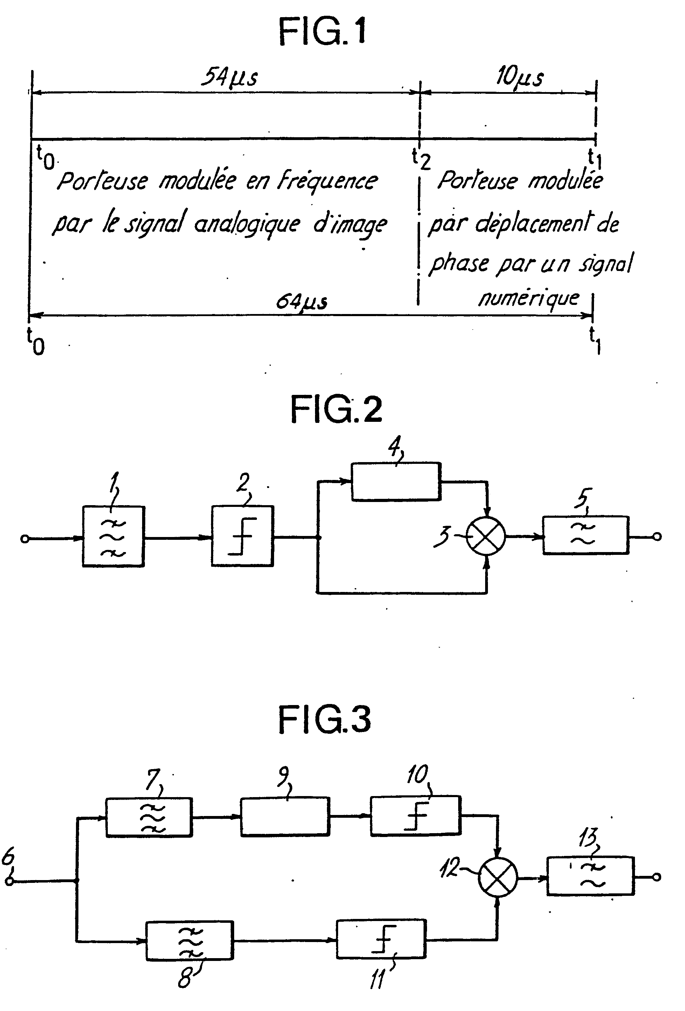

En relation avec la Fig. 1, on rappelle que le signal d'image complet occupe, dans la norme à 625 lignes, 64 microsecondes entre les instants t0 et t1, que le signal d'image utile occupe 54 microsecondes entre t0 et t2, et que le signal de suppression ligne occupe 10 microsecondes entre t2 et t1. Dans le système de radiodiffusion par satellite du groupe C, le signal utile entre t0 et t2 est transmis par modulation de fréquence de la porteuse tandis que les signaux de l'intervalle de suppression sont transmis entre t2 et t1 par modulation numérique de la porteuse. Il faut noter que les signaux compris entre t2 et t1 servent également à reconstruire l'information de synchronisation, la référence du niveau du noir et le signal de référence de la couleur.

Le démodulateur de fréquence analogique de la Fig. 2 comprend un filtre de bande 1 de fréquence centrale F2 et d'une largeur de bande de 27 MHz, par exemple, suivi d'un limiteur d'amplitude 2 dont une sortie est reliée directement à une entrée d'un mélangeur 3 et l'autre sortie est reliée à l'autre entrée du mélangeur 3 par l'intermédiaire d'un circuit à retard 4 dont le retard est de l'ordre de 15 nanosecondes, la sortie du mélangeur 3 étant reliée à l'entrée d'un filtre passe-bas 5 qui délivre le signal d'image utile.

Le circuit de la Fig. 2 peut, comme le montre la Fig. 3, être modifié tout en donnant le même résultat. A la Fig. 3, l'entrée 6 de la porteuse modulée en fréquence est reliée, en parallèle, à deux filtres passe-bande 7 et 8. La sortie du filtre 7 est reliée à l'entrée d'un circuit à retard 9 dont la sortie est reliée à l'entrée d'un limiteur 10. La sortie du filtre 8 est reliée à l'entrée d'un limiteur 11. Les sorties des limiteurs 10 et 11 sont respectivement reliées aux entrées d'un mélangeur 12 dont la sortie est reliée à l'entrée d'un filtre passe-bas 13 qui délivre le signal démodulé. Les filtres 7 et 8 sont identiques au filtre 1, le circuit à retard 9 est identique au circuit 4 et les limiteurs 10 et 11 sont identiques au limiteur 2. L'homme de métier pourra vérifier que les deux montages sont équivalents.

Dans le brevet FR-A-2 312 881, il est décrit un démodulateur différentiel d'ondes modulées par déplacement de phase par des signaux numériques, ce démodulateur comprenant un dispositif à ondes élastiques de surface avec, comme le montre la Fig. 2 de ce brevet, un transducteur d'entrée et deux transducteurs de sortie placés à différentes distances du transducteur d'entrée, les sorties des transducteurs de sortie étant respectivement reliées aux entrées d'un mélangeur.

Un démodulateur de fréquence analogique comprenant un dispositif à ondes acoustiques de surface est décrit dans le brevet US-A-3 936 751.

Enfin, on rappelle que la modulation MDP2-4, décrite dans le brevet EP-A-0 032 325, est démodulée par un simple démodulateur différentiel classique.

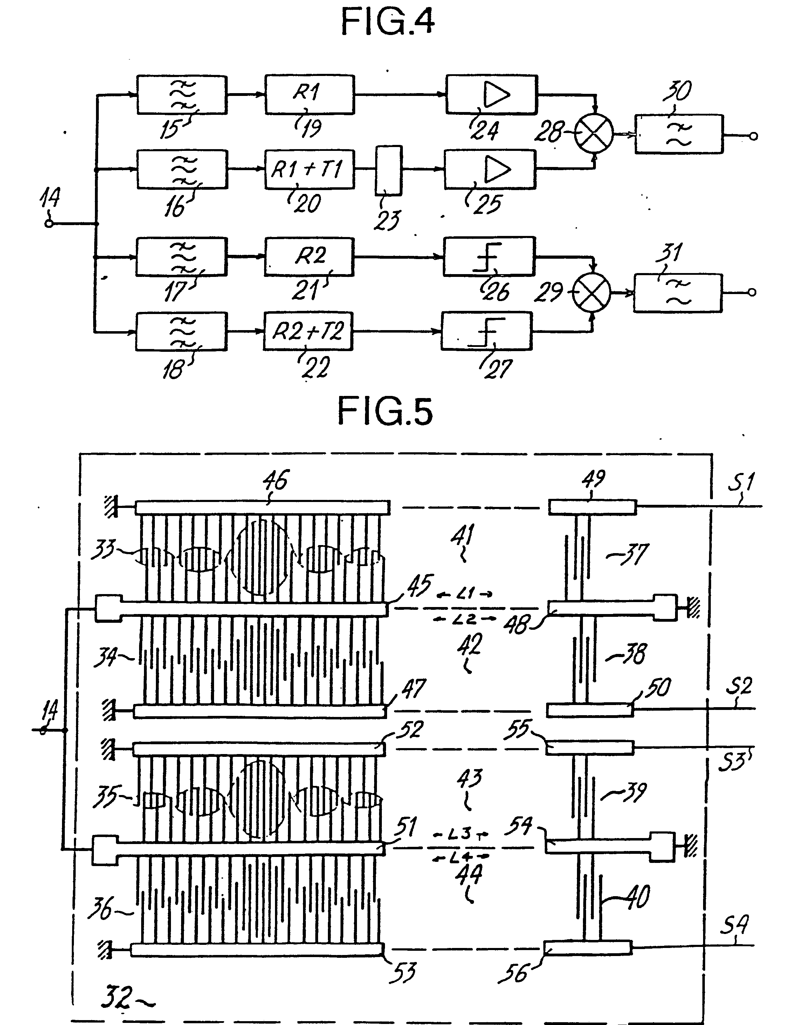

A la Fig. 4, est montré un bloc-diagramme d'un démodulateur suivant l'invention. L'entrée 14 des porteuses modulées est reliée, en parallèle, aux entrées de quatre filtres passe-bande 15 à 18. Les sorties des filtres 15 à 18 sont respectivement reliées aux entrées de quatre lignes à retard 19 à 22. La sortie du circuit à retard 20 est reliée à l'entrée d'un déphaseur de 90° 23. Les sorties des circuits 19 et 23 sont reliées aux entrées de deux amplificateurs 24 et 25. Les sorties des circuits à retard 21 et 22 sont respectivement reliées aux entrées de deux limiteurs 26 et 27. Les sorties des amplificateurs 24 et 25 sont respectivement reliées aux entrées d'un mélangeur 28. Les sorties des limiteurs 26 et 27 sont respectivement reliées aux entrées d'un mélangeur 29. Les sorties des mélangeurs 28 et 29 sont respectivement reliées aux entrées de deux filtres passebas 30 et 31, le filtre 30 délivrant le signal numérique et le filtre 31 délivrant le signal vidéo analogique.

Les deux filtres passe-bande 15 et 16 sont identiques. Ils sont centrés sur la fréquence porteuse F1 et ont une largeur de bande de l'ordre de 21 MHz. Le circuit à retard 19 apporte un retard arbitraire R1 tandis que le circuit à retard 20 apporte un retard (R1 + T1), où T1 est très voisin de la durée d'un bit et doit vérifier la relation $T1 = (2N + 1)/4f_o$, $f_o$ étant la fréquence centrale de porteuse modulée. Dans le cas de la norme UER, COM.T 490, T1 est égal à 49,4 nanosecondes. Les amplificateurs 24 et 25 sont des amplificateurs linéaires identiques. En pratique, l'ensemble des circuits 15, 16, 19, 20, 23, 24, 25, 28 et 30 fonctionne en démodulateur différentiel comme le démodulateur de la Fig. 2 du brevet FR-A-2 312 881. Donc, la porteuse F1 étant modulée par déplacement de phase pendant l'intervalle de temps t2-t1 de la Fig. 1, la sortie du filtre passe-bas 30 délivre le signal numérique modulant.

Les deux filtres passe-bande 17 et 18 sont identiques. Ils sont centrés sur la fréquence porteuse F2 et ont une largeur de bande de 27 MHz. Le circuit à retard 21 apporte un retard arbitraire R2 tandis que le circuit à retard 22 apporte un retard (R2 + T2). La largeur de bande entre les sommets du discriminateur ainsi réalisé est égale à 1/2T2 et la fréquence centrale correspondant à une tension de sortie nulle est définie par la relation $T2 = (2M + 1)/4f_o$. Dans l'exemple de réalisation décrit, T2 est de l'ordre de 15 nanosecondes. En pratique, l'ensemble des circuits 17, 18, 21, 22, 26, 27, 29 et 31 fonctionne comme le démoduleteur de fréquence de le Fig. 3. Donc, la porteuse F2 étant modulée en fréquence pendant l'intervalle de temps t0-t2 de la Fig. 1, la sortie du filtre passe-bas 31 délivre le signal vidéo d'image utile.

On va maintenant décrire des exemples de réalisation de dispositifs à état solide à ondes élastiques de surface qui remplissent chacun les fonctions des filtres 15 à 18 et des circuits à retard 19 à 22.

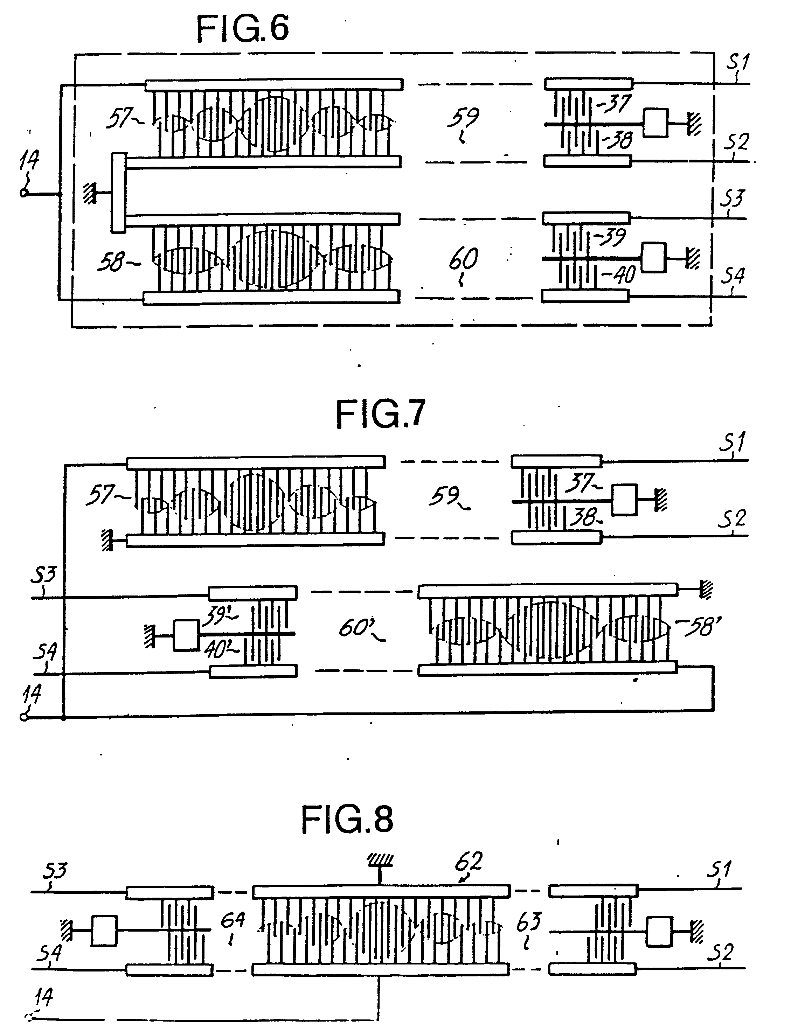

A la Fig. 5, on a montré un dispositif à ondes acoustiques de surface comportant un substrat piézoélectrique 32 sur lequel sont prévus quatre transducteurs d'entrée 33 à 36 et quatre transducteurs de sortie 37 à 40 qui définissent respectivement entre eux quatre pistes 41 à 44 de propagation des ondes acoustiques, chaque piste ayant une largeur égale à la largeur des transducteurs d'entrée.

Les transducteurs d'entrée 33 et 34 ont en commun une électrode 45 qui est reliée à l'entrée de signal 14. Les deux autres électrodes 46 et 47 des transducteurs 33 et 34 sont à la masse. Dans le transducteur 33, les peignes interdigités des électrodes 45 et 46 sont modulés, c'est-à-dire qu'ils sont formés de doigts de longueurs variables, de manière à obtenir une forme prédéterminée de la courbe de réponse en fréquence. Il en est de même pour les peignes interdigités des électrodes 45 et 47 dont les formes sont identiques à celles des peignes interdigités de 45 et 46.

Dans chaque peigne, l'espace entre deux électrodes consécutives de même potentiel est régulier et il est le même pour le peigne d'émission et de réception d'un même ensemble de filtrage. En pratique, cet espace est sensiblement égal à $v/F_1$, où v est la vitesse des ondes à la surface du substrat 32, soit environ 3500 m/s suivant le cristal utilisé, pour les ensembles 33, 34 - 37, 38, et sensiblement égal à $v/F_2$ pour les ensembles 35, 36 - 39, 40.

Les pistes 41 et 42 sont parallèles. Les transducteurs de sortie 37 et 38 ont également en commun une électrode 48 qui est reliée à la masse tandis que les deux autres électrodes 49 et 50 constituent deux électrodes de sortie S1 et S2. Dans l'exemple de réalisation montré, les peignes des électrodes 48 à 50 ont des doigts de longueur constante.

La distance L1 entre les doigts centraux des peignes des transducteurs 33 et 37 est telle que $L1=vR1$, où v est la vitesse de propagation des ondes acoustiques de surface sur le substrat 32. La distance L2 entre les doigts centraux des transducteurs 34 et 38 est telle que $L2=(R1 + T1)$. Comme l'illustre le dessin de la Fig. 5, les doigts centraux de 33 et 34 sont alignés tandis que ceux de 37 et 38 sont décalés.

Les transducteurs 35 et 36 ont aussi en commun une électrode 51 qui est reliée à l'entrée de signal 14. Les deux autres électrodes 52 et 53 des transducteurs 35 et 36 sont à la masse. Dans chacun des transducteurs 35 et 36, les peignes interdigités sont modulés de manière à obtenir également une forme prédéterminée de la courbe de réponse en fréquence. Bien entendu, les réponses en fréquence de la paire 33, 34 et de la paire 35, 36 sont différentes, ainsi que les fréquences centrales de ces courbes de réponse, la première correspondant à F1 et la seconde à F2.

Les pistes 43 et 44 sont également parallèles et, de préférence, parallèles aux pistes 41 et 42. Les transducteurs de sortie 39 et 40 ont également en commun une électrode 54 qui est reliée à la masse tandis que les deux autres électrodes 55 et 56 constituent deux électrodes de sortie S3 et S4.

La distance L3 entre les doigts centraux des peignes de 35 et 39 est telle que $L3=vR2$ tandis que la distance L4 entre les doigts centraux de 36 et 40 est telle que $L4=v(R2 + T2)$. Les doigts centraux de 35 et 40 sont alignés tandis que ceux de 39 et 40 sont décalés.

Les sorties S1 à S4 sont destinées à être respectivement reliées aux entrées des circuits 24 à 27 de la Fig. 4.

On comprendra que les transducteurs d'entrée 33 à 36 remplissent le rôle des filtres 15 à 18 de la Fig. 4 tandis que les pistes 41 à 44 apportent les retards prévus dans les circuits 19 à 22.

Dans la variante montrée à la Fig. 6, on a remplacé les transducteurs d'entrée 33 et 34 par un unique transducteur 57, et les transducteurs 35 et 36 par un unique transducteur 58. Le transducteur 57 a une largeur égale à la somme des largeurs des pistes 41 et 42. Son électrode adjacente au transducteur 58 est à la masse tandis que sa seconde électrode est reliée à l'entrée 14. Le transducteur 57 est également à l'entrée 14. Dans le transducteur 56, l'électrode adjacente à 57 est aussi à la masse tandis que l'autre électrode est reliée à l'entrée 14. Sa courbe de réponse est identique à celle de 35 et 36.

Du côté sortie, les transducteurs 37 à 40 peuvent être utilisés avec, de préférence, leurs électrodes 48 et 54 le moins large possible de manière à ne perdre qu'une partie minimale des ondes lancées par 57 et 58. Les doigts centraux des transducteurs 57 et 58 sont positionnés par rapport aux transducteurs de sortie comme dans l'exemple de réalisation de la Fig. 5.

Dans l'exemple de réalisation de la Fig. 6, les pistes 41 et 42, d'une part, et 43 et 44, d'autre part, ne forment respectivement que des pistes uniques 59 et 60 correspondant à la largeur des transducteurs 57 et 58.

Dans une autre variante montrée à la Fig. 7, on retrouve le transducteur d'entrée 57 et les transducteurs de sortie 37 et 38. Le transducteur d'entrée 58 est remplacé par un transducteur d'entrée 58' de même dimension et même forme tandis que, similairement, les transducteurs de sortie 39 et 40 sont remplacés par des transducteurs de sortie 39' et 40'. La piste 60' entre ces transducteurs est dirigée parallèlement à la piste 59, mais en sens inverse de cette dernière.

Dans une autre variante montrée à la Fig. 8, les transducteurs 57 et 58' sont remplacés par un seul transducteur d'entrée 62 émettant des ondes acoustiques symétriquement sur des pistes 63 et 64, dont l'une peut être assimilée à la piste 59 et l'autre à la piste 60' de la Fig. 7. A l'autre extrémité de la piste 63, sont prévus les transducteurs de sortie 37 et 38 et, à l'autre extrémité de la piste 67, les transducteurs de sortie 39 et 40. Bien entendu, cette variante de réalisation suppose que les fréquences F1 et F2 sont identiques, la forme des peignes du transducteur d'entrée étant prévue en conséquence.

Bien entendu, du fait de la réciprocité, il serait possible dans chaque exemple de réalisation décrit ci-dessus, d'échanger les caractéristiques des peignes d'émission et de réception, la réponse impulsionnelle et de réception, la réponse en fréquence globale, comme la réponse impulsionnelle restant inchangée. On rappelle que c'est évidemment l'ensemble peigne d'émission - peigne de réception qui détermine les réponses impulsionnelles ou en fréquence souhaitées.

## Revendications

1. Circuit de réception d'ondes électriques modulées tantôt en fréquence par un signal analogique, tantôt en phase par un signal numérique, comportant un dispositif à ondes acoustiques de surface, caractérisé en ce que sur le substrat (32) du dispositif à ondes acoustiques de surface, sont prévus deux paires de transducteurs d'entrée (33, 34; 35, 36) reliées, en parallèle, à l'entrée du circuit de réception, les transducteurs d'entrée (33, 34; 35, 36) lançant des ondes acoustiques correspondant aux signaux appliqués à ladite entrée sur deux paires de pistes (41, 42; 43, 44) aboutissant à deux paires de transducteurs de réception (37, 38; 39, 40), les longueurs des pistes de chaque paire de pistes étant différentes, les sorties des transducteurs de sortie de la première paire (37, 38) étant respectivement reliées aux deux entrées d'un premier mélangeur (28) dont la sortie délivre le signal numérique reçu et les sorties des transducteurs de la seconde paire (39, 40) étant respectivement reliées aux entrées de deux limiteurs (26, 27) dont les sorties sont respectivement reliées aux deux entrées d'un second mélangeur (29) dont la sortie délivre le signal analogique, la différence de longueur des pistes de la première paire (41, 42) apportant un retard de l'ordre de la durée d'un bit et la différence de longueur des pistes de la seconde paire (43, 44) apportant un retard égal à l'inverse du double de la largeur de bande entre les sommets du discriminateur ainsi constitué.

2. Circuit de réception suivant la revendication 1, caractérisé en ce que chaque paire d'ensembles, comprenant chacun une paire de transducteurs d'entrée et la paire de transducteurs de sortie associés, comporte des peignes modulés lui donnant des réponses impulsionnelle et fréquentielle déterminées.

3. Circuit de réception suivant la revendication 1 ou 2, caractérisé en ce que chaque dite paire de transducteurs est remplacée par un seul transducteur (57 ou 58) de largeur double.

4. Circuit de réception suivant l'une des revendications 1 à 3, caractérisé en ce que lesdites paires de pistes (59, 60) sont parallèles, mais de sens de propagation inversés.

5. Circuit de réception suivant la revendication 1, caractérisé en ce que lesdites paires de transducteurs d'entrée sont remplacées par un transducteur d'entrée unique bidirectionnel (62) avec, d'un côté, une paire de pistes (63) vers la première paire de transducteurs de sortie et, de l'autre côté, une autre paire de pistes (64) conduisant à l'autre paire de transducteurs de sortie.

## Patentansprüche

1. Empfangsschaltung für elektrische Wellen, die zu einer Zeit mit einem analogen Signal frequenzmoduliert und zu einer anderen Zeit mit einem digitalen Signal phasenmoduliert sind, und die eine akustische Oberflächen-Wellen-Vorrichtung enthält, dadurch gekennzeichnet, daß auf dem Substrat (32) der akustischen Oberwellen-Vorrichtung zwei Paare von Eingangswandlern (33, 34; 35, 36) vorgesehen sind, die parallel mit dem Eingang der Empfangsschaltung verbunden sind, wobei die Eingangswandler (33, 34; 35, 36) akustische Wellen auslösen, die den dem genannten Eingang entlang zweier Paare von Wegen (41, 42; 43, 44) zugeführten Signalen entsprechen, die bei zwei Paaren von Eingangswandlern (37, 38; 39, 40) enden, daß die Länge der Wege jedes Paares von Wegen unterschiedlich ist, daß die Ausgänge der Ausgangswandler des ersten Paares (37, 38) entsprechend mit den beiden Eingängen eines ersten Mischers (28) verbunden sind, dessen Ausgang das empfangene digitale Signal liefert, und daß die Ausgänge der Wandler des zweiten Paares (39, 40) entsprechend mit den Eingängen von zwei Begrenzern (26, 27) verbunden sind, deren Ausgänge entsprechend mit den beiden Eingängen eines zweiten Mischers (29) verbunden sind, dessen Ausgang das analoge Signal liefert, daß der Längenunterschied der Wege des ersten Paares (41, 42) eine Verzögerung in der Größenordnung von einem Bit einführt und der Längenunterschied der Wege des zweiten Paares (43, 44) eine Verzögerung einführt, die gleich dem Inversen der doppelten Bandbreite zwischen den Spitzen des so gebildeten Diskriminators ist.

2. Empfangsschaltung nach Anspruch 1, dadurch gekennzeichnet, daß jedes Paar von Sätzen, die jeweils ein Paar von Eingangswandlern und das zugehörige Paar von Ausgangswandlern umfassen, modulierte Kämme aufweist, die ihm bestimmte Impuls- und Frequenzanworten geben.

3. Empfangsschaltung nach Anspruch 1 oder 2, dadurch gekennzeichnet, daß jedes der genannten Wandlerpaare durch einen einzelnen Wandler (57 oder 58) der doppelten Breite ersetzt ist.

4. Empfangsschaltung nach einem der Ansprüche 1 bis 3, dadurch gekennzeichnet, daß die genannten Paare von Wegen (59, 60) parallel sind, aber die Ausbreitungsrichtung entgegengesetzt ist.

5. Empfangsschaltung nach Anspruch 1, dadurch gekennzeichnet, daß die genannten Paare von Eingangswandlern durch einen einzelnen bidirektionalen Eingangswandler (62) ersetzt sind, mit zwei Paaren von Wegen (63) in Richtung auf das erste Paar von Ausgangswandlern auf der einen Seite, und mit einem anderen Paar von Wegen (64), die zu dem anderen Paar von Ausgangswandlern führen, auf der anderen Seite.

## Claims

1. A receiving circuit for the reception of electric waves modulated at one time in frequency by an analog signal, at another time in phase by a digital signal, comprising a surface acoustic wave device, characterized in that on the substrate (32) of the surface acoustic wave device are foreseen two pairs of input transducers (33, 34; 35, 36) connected, in parallel, at the input of the receiving circuit, the input transducers (33, 34; 35, 36) initiating acoustic waves corresponding to the signals applied to the said input on two pairs of paths (41, 42; 43, 44) ending at two pairs of receiving transducers (37, 38; 39, 40), the lengths of the paths of each pair of paths being different, the output of the output transducers of the first pair (37, 38) being respectively connected to the two inputs of a first mixer (28) whose output yields the received digital signal and the outputs of the second pair of transducers (39, 40) being respectively connected to the inputs of two limiters (26, 27) whose outputs are respectively connected to the two inputs of a second mixer (29) whose output yields the analog signal, the different lengths in paths of the first pair (41, 42) introducing a delay of the order of one bit and the different lengths in paths of the second pair (43, 44) introducing a delay equal to the inverse of twice the bandwidth between the peaks of the discriminator thus constituted.

2. A receiving circuit according to claim 1, characterized in that each pair of sets, comprising each a pair of input transducers and the associated pair of output transducers, has modulated combs giving it determined impulse and frequency responses.

3. A receiving circuit according to claim 1 or 2, characterized in that each said pair of transducers is replaced by a single transducer (57 or 58) having double the width.

4. A receiving circuit according to anyone of claims 1-3, characterized in that the said pairs of paths (59, 60) are parallel, but propagating in opposite directions.

5. A receiving circuit according to claim 1, characterized in that the said pairs of input transducers are replaced by a single bidirectional input transducer (62) with, on one side, a pair of paths (63) towards the first pair of output transducers and, on the other side, another pair of paths (64) leading to the other pair of output transducers.

# FIG.1

54 µs | 10 µs

$t_0$ | $t_2$ | $t_1$

*Porteuse modulée en fréquence par le signal analogique d'image* | *Porteuse modulée par déplacement de phase par un signal numérique*

64 µs

$t_0$ | $t_1$

# FIG.2

# FIG.3

1

0 138 727

# FIG.4

# FIG.5

3

0 138 727

# FIG.6

57~   59   -37 -38

14   S1 S2 S3 S4

58~   60   -39 -40

# FIG.7

57~   59~   37~ 38~   S1 S2

S3   39~ 40~   60'   -58'   S4

14

# FIG.8

S3   54   64   62   63   S1

54   14   S2